# EUROPÄISCHE PATENTSCHRIFT

(11) **EP 1 336 989 B1**
(45) Veröffentlichungstag und Bekanntmachung des Hinweises auf die Patenterteilung: **08.06.2011**
(21) Anmeldenummer: 03001555.6
(22) Anmeldetag: 23.01.2003
(51) Int. Cl.: H01L 21/336, H01L 29/06, H01L 29/78

(54) **Transistorbauelement**
Transistor device
Dispositif transistor

(30) Priorität: 18.02.2002 DE 10206739
(43) Veröffentlichungstag der Anmeldung: 20.08.2003
(73) Patentinhaber: Infineon Technologies AG, 85579 Neubiberg (DE)
(72) Erfinder: Taddiken, Hans, 81737 München (DE)
(74) Vertreter: Schoppe, Fritz

(56) Entgegenhaltungen:
- DE-A1- 3 046 749
- DE-A1- 10 021 643
- US-A- 4 766 474
- US-A- 5 119 149
- US-A- 5 187 552
- US-A- 5 252 848
- US-A- 5 907 173
- US-A- 6 033 948
- US-A- 6 069 386
- US-B1- 6 222 229
- MARTIN R A ET AL: "CONSIDERATIONS FOR PRODUCT RELIABILITY OF HIGH VOLTAGE INTEGRATED CIRCUITS" ELECTRO, ELECTRONIC CONVENTIONS MANAGEMENT. LOS ANGELES, US, 23. April 1985 (1985-04-23), Seiten 1-5, XP000023295
- SHACKLE P W: "CUSTOM HIGH VOLTAGE INTEGRATIONS FOR INDUSTRY" ELECTRO, ELECTRONIC CONVENTIONS MANAGEMENT. LOS ANGELES, US, 1. April 1985 (1985-04-01), Seiten 1-3, XP000023296
- PATENT ABSTRACTS OF JAPAN vol. 007, no. 251 (E-209), 8. November 1983 (1983-11-08) & JP 58 137256 A (HITACHI SEISAKUSHO KK), 15. August 1983 (1983-08-15)
- PATENT ABSTRACTS OF JAPAN vol. 010, no. 141 (E-406), 24. Mai 1986 (1986-05-24) & JP 61 003458 A (NIPPON DENKI KK), 9. Januar 1986 (1986-01-09)

## Beschreibung

Die vorliegende Erfindung bezieht sich auf ein Transistorbauelement, und hier insbesondere auf einen LDMOS-Transistor für Hochfrequenz-Leistungs-Anwendungen (LDMOS = lateraler diffundierter MOS). Insbesondere bezieht sich die vorliegende Erfindung auf LDMOS-Transistoren mit einem leicht dotierten Drainbereich (LDD-Bereich), welche reduzierte parasitäre Kapazitäten aufweisen.

Bei LDMOS-Transistoren für Hochfrequenz-Leistungs-Anwendungen wird das Verhalten dieser Transistoren unter anderem durch die parasitären Kapazitäten bestimmt. Ein stetes Ziel in der Entwicklung dieser Transistoren besteht daher darin, diese unerwünschten, parasitären Kapazitäten zu reduzieren.

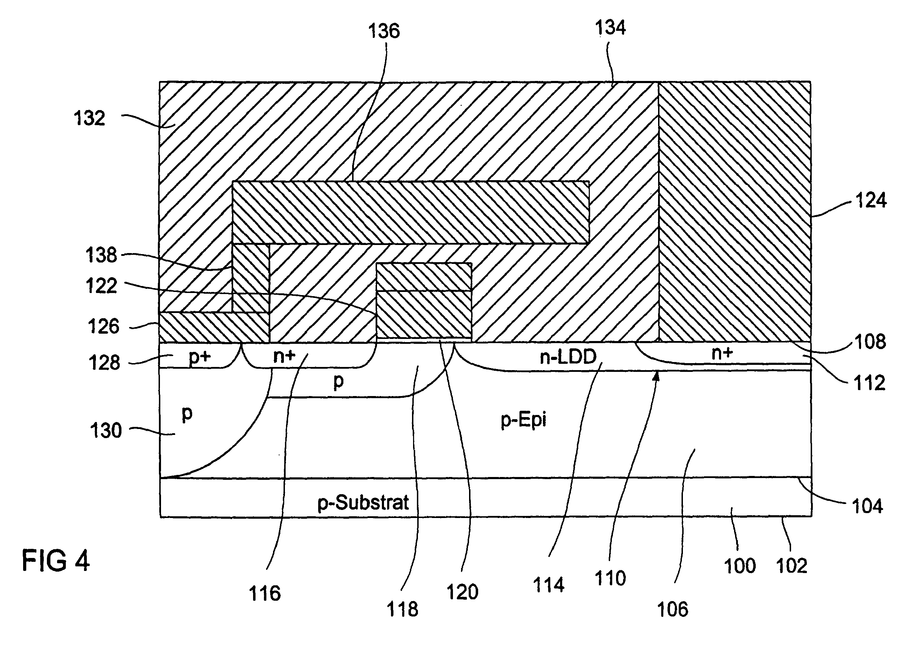

Ein im Stand der Technik bekannter Ansatz besteht darin, eine Abschirmung, ein sogenanntes Masse-Shield, über dem Gate und einen Teil des angrenzenden LDD-Bereichs anzuordnen. In Fig. 4 wird nachfolgend anhand eines n-Kanal LDMOS-Transistor diese bekannte Abschirmung und deren Effekt näher erläutert. In Fig. 4 ist ein bekannter LDMOS-Transistor gezeigt, der ein Substrat 100 umfasst, das eine erste, untere Oberfläche 102 und eine zweite, obere Oberfläche 104 aufweist. Bei dem in Fig. 4 gezeigten Beispiel eines LDMOS-Transistors ist das Substrat 100 ein p-Substrat. Auf dem p-Substrat 100 ist eine Epitaxieschicht 106 gebildet, die in dem dargestellten Beispiel ebenfalls eine p-Epitaxieschicht ist. In der p-Epitaxieschicht 106, benachbart zu einer oberen, dem p-Substrat 100 abgewandten Oberfläche 108 derselben, sind die aktiven Bereiche des LDMOS-Transistors gebildet. Die aktiven Bereiche umfassen einen Drainbereich 110, der einen ersten Drainabschnitt 112 mit einer hohen Dotierung (n-Drainabschnitt) und einen zweiten Drainabschnitt 114 mit einer, verglichen zum ersten Drainabschnitt niedrigeren Dotierung umfasst. Der zweite Drainabschnitt 114 ist der sogenannte LDD-Bereich. Ferner umfasst der LDMOS-Transistor gemäß Fig. 4 einen hochdotierten Sourcebereich 116 (n⁺-Sourcebereich). Zwischen dem Sourcebereich 116 und dem zweiten Drainabschnitt 114, dem LDD-Bereich, ist ein Kanalbereich 118 definiert, der durch eine Diffusion von p-dotierendem Material bei dem gezeigten Beispiel in dem Bereich zwischen dem Sourcebereich 116 und dem Drainbereich 114 gebildet wurde. Der für die laterale Diffusion des Kanalbereichs 118 erforderliche p-Bereich wurde vor Erzeugen des Sourcebereichs 116 eingebracht und durch thermische Behandlung des Elements in den Bereich 118 diffundiert.

Im Bereich oberhalb des Kanalbereichs 118 ist ein Gateoxid 120 gebildet, auf dem das Gate 122 gebildet ist. Ferner ist ein Drainkontakt (Drain) 124 gebildet, der mit dem ersten Drainabschnitt 112 in Kontakt ist, wobei zwischen dem Drainabschnitt 112 und der Drain 124, dem Drainanschluss, ein Ohmscher Kontakt existiert. Ferner ist ein Sourcekontakt (Source) 126 in Verbindung mit dem Sourcebereich 116 auf der Oberfläche 108 angeordnet.

Hinsichtlich der in Fig. 4 gezeigten Struktur ist festzuhalten, dass das p-Substrat 100 einen, in Fig. 4 nicht gezeigten, Rückseitenkontakt aufweist, über den die Source 126 mit einem Bezugspotential verbindbar ist. Hierzu ist zum einen der niederohmige p⁺-Bereich 128 als Ohmscher Kontakt vorgesehen, sowie der weitere p-Bereich 130, so dass der Sourcekontakt 126 über den Rückseitenkontakt des p-Substrats 100 kontaktiert wird. Ferner ist, wie in Fig. 4 zu sehen ist, eine isolierende Schicht 132 vorgesehen, die ganzflächig auf der Oberfläche 108 abgeschieden ist, um so die Source 126 und das Gate 122 einzubetten. Der Drainbereich 124 ist zu einer Oberfläche 134 der isolierenden Schicht 132 herausgeführt.

Wie in Fig. 4 ferner gezeigt ist, ist in der isolierenden Schicht 132 ein Abschirmelement 136 derart angeordnet, dass dieses bezüglich der Oberfläche 108 der p-Epitaxieschicht weiter beabstandet ist als die aus dem Gate 122 und dem Gateoxid 120 bestehende Gatestruktur. Ferner ist das Abschirmelement 136 über einen Abschnitt 138 mit der Source 126 und damit dem Rückseitenkontakt des p-Substrats 100 verbunden, wodurch das Abschirmelement 136 mit einem Bezugspotential, z. B. Masse, beaufschlagt werden kann. Das Abschirmelement 136 erstreckt sich innerhalb der isolierenden Schicht 132 ausgehend von dem Verbindungselement 138 oberhalb des Sourcebereichs 116 über das Gate 122 bis in den n LDD-Bereich 144.

Die Wirkungsweise des Abschirmelements 136 besteht darin, dass hierdurch elektrische Feldlinien während des Betriebs des Transistorelements, die sich zwischen dem Gate 122 und dem n LDD-Bereich 114 ergeben, "umgeleitet" werden, so dass dieselben auf dem Abschirmelement 136 enden, wodurch die Gate-Drain-Kapazität (C_{GD}) reduziert wird. Eine ähnliche Transistorstruktur, wie sie beispielhaft anhand der Fig. 4 beschrieben wurde, ist z. B. in den US-Patenten 4,172,260, 5,252,848 und 5,187,552 beschrieben, wobei das US-Patent 5,187,552 alternativ eine Anordnung eines ersten Abschirmelements zwischen der Source und dem Gate und eines zweiten Abschirmelements zwischen der Drain und dem Gate beschreibt.

Der Nachteil dieser bekannten LDMOS-Transistorstruktur besteht darin, dass das dort verwendete Masse-Shield 136 über dem Gate 122 und einem Teil des angrenzenden LDD-Bereichs angeordnet ist, wodurch sich zwar eine Reduzierung der Gate-Drain-Kapazität herbeiführen lässt, jedoch gleichzeitig eine Erhöhung der Gate-Source-Kapazität erfolgt.

Eine andere Anordnung der Abschirmung wird in US-Patent 6,069,386 näher erläutert. Bei dieser Lösung wird ein LDMOS-Transistor gebildet, wobei auf einer Oberfläche eines Substrats oder einer Epitaxieschicht, in der entsprechend aktive Bereiche gebildet sind, eine Isolationsschicht abgeschieden wird, die auch das Gate und das Gateoxid bedeckt. In die Isolationsschicht werden Kontaktlöcher eingebracht, durch die eine Drain-Metallisierung, eine Source-Metallisierung und eine Gate-Metallisierung erzeugt werden. Diese Metallisierungen sind in Form von Metall-Streifen ausgebildet und liegen aufgrund der gleichzeitigen Herstellung auf gleicher Höhe.

Zwischen dem Drain-Metallisierungsstreifen und dem Gate-Metallisierungsstreifen ist ein weiterer Metallstreifen parallel angeordnet, der auf der Isolationsschicht derart gebildet ist, dass dieser einem niedrig dotierten,Drainbereich gegenüberliegt. Dieser weitere Metallstreifen ist ferner mit dem Source-Metallstreifen verbunden. Bei dieser Anordnung wird zwar vermieden, dass ein Abschirmelement über die Gatestruktur geführt wird, jedoch tritt ebenfalls eine Erhöhung der Gate-Source-Kapazität auf, da dort zur Reduzierung des Gate-Widerstandes eine Metallisierung in der Form der oben genannten Metall-Streifen auf dem Gate angeordnet ist. Durch die sehr dicht geführten parallelen Metallstreifen vom Gate und der Abschirmung tritt wiederum ein ähnlicher Effekt auf, wie bei dem erstgenannten Beispiel aus dem Stand der Technik (siehe Fig. 4), bei dem eine Metallisierung oberhalb des Gates liegt, so dass auch hier eine Erhöhung der Gate-Source-Kapazität herbeigeführt wird.

Ein weiterer Nachteil dieser bekannten Vorgehensweise besteht in einem erhöhten Prozessrisiko während der Herstellung der Struktur, da hier, was bei CMOS-Prozessen unüblich ist, eine Isolationsschicht vorgesehen ist, in der ein Kontaktloch zum Gate geöffnet wird, wobei sich das Gate über einem dünnen Gate-Oxid befindet. Ein Problem bei dieser Vorgehensweise besteht darin, dass hier während der Herstellungsschritte ein Durchbruch des Gate-Oxids auftreten kann, was zu einem erhöhten Prozessrisiko führt, und somit die Zahl der zu erwartenden fehlerhaften Elemente erhöht, so dass der Ausschuss, verglichen mit üblichen CMOS-Herstellungsverfahren deutlich erhöht wird.

Noch ein weiterer Nachteil dieser Vorgehensweise besteht darin, dass die zu öffnenden Kontaktbereiche für das Gate photolithographisch festzulegen sind, wodurch sich aufgrund der Justagefehler und weiterer, systemimmanenter Ungenauigkeiten eine minimale Transistorlänge (Gatelänge) ergibt, die deutlich oberhalb der mit herkömmlichen CMOS-Verfahren erreichbaren Größen ist, so dass die Abmessungen der erzeugbaren Transistoren nicht minimiert sind. Eine Reduktion der Gatelänge, die zur Erzielung einer besseren Performance erforderlich ist, ist daher mit dieser Anordnung nicht möglich.

Weitere Formen von Abschirmungen oder Sourceelektroden, die sich über das Gate erstrechen, sind aus dem US-Patent 5,119,149 sowie aus der Offenlegungschritt DE 100 21 643 A1 bekannt.

Ausgehend von diesem Stand der Technik liegt der vorliegenden Erfindung die Aufgabe zugrunde, ein verbessertes Transistorelement zu schaffen, welches auf einfache Art und Weise hergestellt werden kann, und bei welchem auf einfache Art und Weise eine Gate-Drain-Kapazität niedrig gehalten werden kann, bei gleichzeitiger Reduzierung der Gate-Source-Kapazität.

Diese Aufgabe wird durch ein Transistorelement nach Anspruch 1 gelöst.

Die vorliegende Erfindung schafft ein Transistorbauelement, unter anderem mit einem Substrat, einem Sourcebereich, der in dem Substrat gebildet ist, einem Drainbereich, der in dem Substrat gebildet ist, wobei der Drainbereich einen ersten Drainabschnitt mit einer ersten Dotierungskonzentration und einen zweiten Drainabschnitt mit einer zweiten Dotierungskonzentration aufweist, die niedriger ist als die erste Dotierungskonzentration, einem Kanalbereich zwischen dem Sourcebereich und dem zweiten Drainabschnitt, einem Gateoxid oberhalb des Kanalbereichs, einem Gate oberhalb des Gateoxids und des Kanalbereichs, einer isolierenden Schicht, die derart auf dem Substrat angeordnet ist, dass das Gate durch die isolierende Schicht bedeckt ist, und einem Abschirmelement, das innerhalb der isolierenden Schicht oberhalb des zweiten Drainabschnitts zwischen dem Gate und dem ersten Drainabschnitt angeordnet ist und bezüglich einer Substratoberfläche weiter von derselben beabstandet ist als das Gate.

Ferner ist ein weiteres Masse-Shield über dem Sourcebereich vorgesehen, wobei dieses Shield so ausgebildet ist, dass es das Gate nicht überdeckt. Eine Verbindung dieses zusätzlichen Masse-Shields zu einem Bezugspotential, wie beispielsweise Masse, ist möglich und erfolgt an einem Ende des Transistors. Die Abschirmelemente (Masse-Shield) oberhalb des LDD-Bereichs und oberhalb des Sourcebereichs sind durch leitfähige Stege miteinander verbunden. Hierdurch wird die elektrische Anbindung des Drain-seitigen Abschirmelements verbessert. Vorzugsweise erfolgt auch hier eine Verbindung des Abschirmelements gegen Masse, beispielsweise durch Verbinden der zwei Abschirmelemente mit einem Bezugspotential, z. B. Masse. Alternativ können die zwei Abschirmelemente oberhalb der genannten Bereiche auch über den Sourcekontakt und den Rückseitenkontakt mit dem Bezugspotential, z. B. Masse, verbunden sein.

Gegenüber dem oben beschriebenen Stand der Technik vermeidet die erfindungsgemäße Anordnung eine Abschirmung oberhalb des Gates und somit eine entsprechende Erhöhung der Kapazitäten. Ferner ermöglicht die Anordnung des Abschirmelements innerhalb der isolierenden Schicht, oberhalb des Gates eine Verbesserung der Reduzierung der Kapazität zwischen Gate und Drain, da hier der Abstand zwischen Gate und Abschirmelement optimiert werden kann, unabhängig von der Anordnung der übrigen Metallisierungen.

Ein Vorteil der vorliegenden Erfindung besteht darin, dass diese die oben beschriebenen Wirkungen unter Verwendung herkömmlicher, standardisierter Prozessschritte erreicht, welche kein Prozessrisiko und damit kein hohes Ausschussrisiko in sich bergen.

Erfindungsgemäß wird das Abschirmelement (Masse-Shield) nur über einen Teil des Drain-Bereichs angeordnet, nicht jedoch über dem Gate. Die Reduktion der Kapazität zwischen Gate und Drain erfolgt aufgrund des vorgesehenen Masse-Shieldes, auf dem die Feldlinien enden. Im Gegensatz zum Stand der Technik ergibt sich jedoch hier eine deutlich geringere Gate-Source-Kapazität.

Ein wesentlicher Aspekt der vorliegenden Erfindung besteht darin, dass hier eine Reduktion der Gate-Drain-Kapazität erreicht wird, ohne dass gleichzeitig eine spürbare Erhöhung der Gate-Source-Kapazität bewirkt, wie dies bei den oben beschriebenen Ansätzen gemäß dem Stand der Technik der Fall ist. Damit ergibt sich eine Verbesserung der Performance.

Vorzugsweise umfasst das Substrat des Transistorbauelements ein Trägersubstrat, auf dem eine Epitaxieschicht aufgewachsen ist, in der die aktiven Bereiche des Bauelements gebildet sind.

Bevorzugte Weiterbildungen der vorliegenden Anmeldung sind in den Unteransprüchen definiert.

Nachfolgend werden anhand der beiliegenden Zeichnungen bevorzugte Ausführungsbeispiele der vorliegenden Erfindung näher erläutert. Es zeigen:
Fig. 1 ein Transistorbauelement gemäß einem ersten Beispiel bei dem ein Abschirmelement lediglich im Bereich oberhalb des Drain-Bereichs angeordnet ist;
Fig. 2 ein zweites Beispiel einen Transistorbauelements, bei dem basierend auf dem ersten Beispiel zusätzlich ein Abschirmelement oberhalb des Sourcebereichs angeordnet ist;
Fig. 3 eine Draufsicht eines Ausführungsbeispiels des erfindungsgemäßen Transistorbauelements, bei dem basierend auf dem anhand der Fig. 2 gezeigten zweiten Ausführungsbeispiel die zwei Abschirmelemente elektrisch miteinander verbunden sind; und
Fig. 4 ein im Stand der Technik bekannter n-Kanal LDMOS-Transistor mit Masse-Shield.

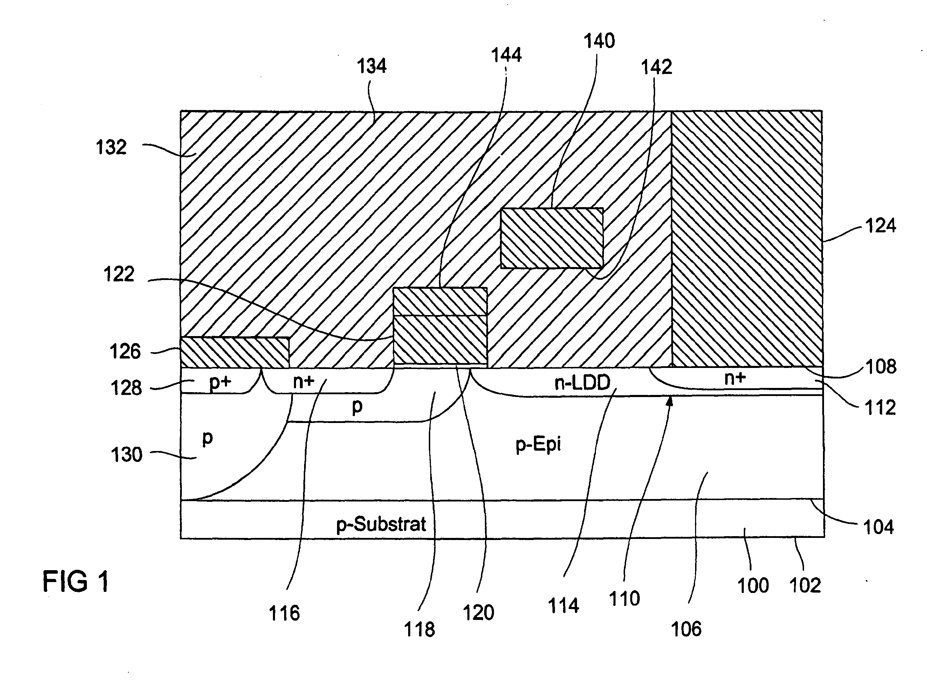

Anhand der Fig. 1 bis 3 werden nachfolgend Transistorelemente beschrieben, wobei Elemente, die bereits anhand der Fig. 4 beschrieben wurden, mit gleichen Bezugszeichen versehen werden, und nicht erneut beschrieben werden.

In Fig. 1 ist ein erstes Beispiel eines Transistorbauelements gezeigt, welches ein Substrat umfasst, das ein p-Trägersubstrat 100 aufweist, auf dessen oberer Oberfläche 104 eine p-Epitaxieschicht aufgewachsen ist, in der aktive Bereiche des Transistorelements festgelegt sind. Das Gate 122 ist bei dem in Fig. 1 gezeigten Beispiel aus einem Gate-Material gebildet, auf dessen Oberfläche beispielsweise noch ein Silizid abschieden ist. Anders als bei den im Stand der Technik bekannten Transistorbauelementen ist bei diesem Transistorbauelement ein Abschirmelement 140 vorgesehen, das, wie zu erkennen ist, innerhalb der isolierenden Schicht 132 angeordnet ist. Das Abschirmelement 140 ist oberhalb des n LDD-Bereichs 114 zwischen dem Gate 122 und dem Drainkontakt 124 angeordnet. Ferner ist der Abstand einer unteren, dem Substrat 100, 106 zugewandten Oberfläche 142 des Abschirmelements 140 von der Oberfläche 108 der p-Epitaxieschicht 106 größer als ein Abstand einer oberen, dem Substrat 100, 106 abgewandten Oberfläche 144 des Gates 122 von der Oberfläche 108.

Verglichen mit den bekannten Anordnungen, bei denen sich das Abschirmelement über das Gate erstreckt, wird erreicht, dass hier zusätzlich zu der Reduzierung der Gate-Drain-Kapazität auch noch eine Reduzierung der Gate-Source-Kapazität herbeigeführt wird.

Das Abschirmelement 140 wird an einem Ende des Transistors mit einem Bezugspotential, z. B. Masse oder einem anderen geeigneten Potential, verbunden.

Bei dem in Fig. 1 dargestellten Beispiel ist die isolierende Schicht 132 beispielsweise eine SiO₂-Schicht.

Die Source 126 ist auch hier über einen Ohmschen Kontakt 128 und einen p-Bereich 130 mit dem p-Substrat und der Rückseitenkontaktierung desselben verbunden, und wird hier entsprechend auf ein Bezugspotential, z. B. Masse oder ein anderes geeignetes Potential, gelegt.

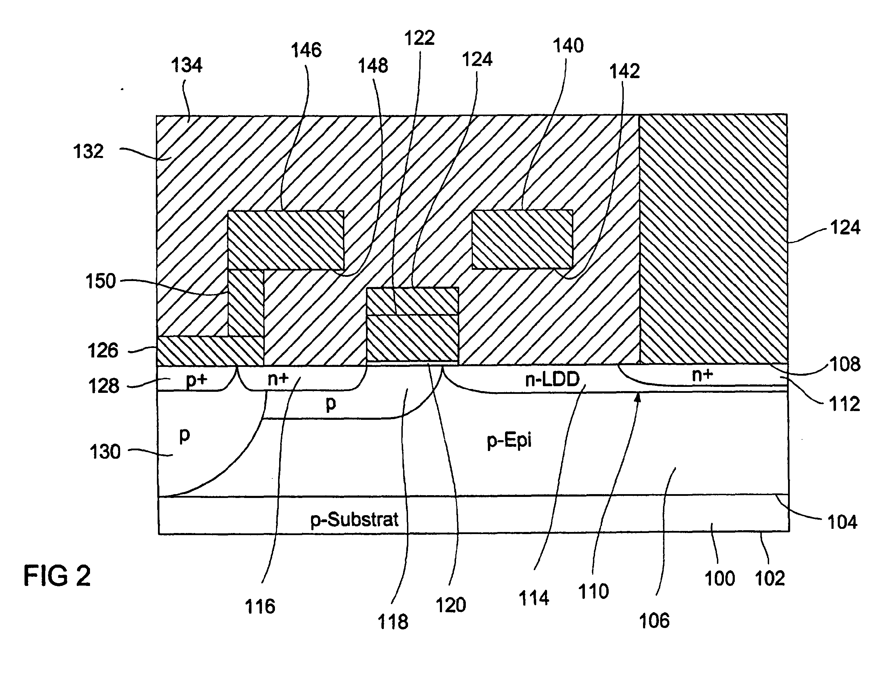

Anhand der Fig. 2 wird nachfolgend ein weiteres Beispiel eines Transistorbauelements näher erläutert. Verglichen mit Fig. 1 unterscheidet sich das in Fig. 2 dargestellte Beispiel dadurch, dass zusätzlich zu dem Abschirmelement 140 ein weiteres Abschirmelement 146 vorgesehen ist, das ähnlich dem Abschirmelement 140 in der isolierenden Schicht 132 angeordnet ist. Das weitere Abschirmelement 146 ist oberhalb des Sourcebereichs 116 angeordnet und erstreckt sich zwischen der Source 126 und dem Gate 122. Ähnlich wie das Abschirmelement 140 ist der Abstand einer unteren, dem Substrat 100, 106 zugewandten Oberfläche 148 des weiteren Abschirmelements zu der Oberfläche 108 der p-Epitaxieschicht 106 größer als ein Abstand der oberen Oberfläche 144 des Gates 122 zu der Oberfläche 108. Obwohl in Fig. 2 die vorteilhafte Ausgestaltung gezeigt ist, bei der das Abschirmelement 140 und das weitere Abschirmelement 146 höhenmäßig bezüglich der Oberfläche 108 der p-Epitaxieschicht 106 gleich angeordnet ist, können diese Abschirmelemente auch höhenmäßig unterschiedliche Abstände zu der Oberfläche 108 haben, wobei es jedoch herstellungstechnisch bevorzugt ist, diese Höhen gleich zu halten. Die Wirkung des weiteren Abschirmelements 146 ist derart, dass Feldlinien, die von der Drainmetallisierung 124 in Richtung Gate 122 ausgehen und nicht auf der Abschirmung 140 enden, sondern an dieser vorbei gehen, dann überwiegend auf dem weiteren Abschirmelement 146 enden, so dass hier die Gate-Drain-Kapazität stark reduziert wird und die Gate-Source-Kapazität geringer ist, als in der Anordnung gemäß dem Stand der Technik nach Fig.4.

Bei dem in Fig. 2 gezeigten Beispiel sind das Abschirmelement 140 und das weitere Abschirmelement 146 nicht miteinander verbunden, und für sich jeweils mit einem Bezugspotential beaufschlagbar, z. B. mit einem Massepotential. Die entsprechenden Abschirmelemente sind dann jeweils an den Enden des Transistors mit dem Massepotential verbunden. Alternativ kann das weitere Abschirmelement 146 über das in Fig. 2 gezeigte zusätzliche Verbindungselement 150 mit der Source 126 verbunden sein, die ihrerseits über den Rückseitenkontakt des p-Substrats 100, auf die oben beschriebene Art und Weise, mit einem Bezugspotential, z. B. Masse verbunden ist, so dass in diesem Fall ein weiterer, externer Anschluss für das weitere Anschlusselement 146 nicht erforderlich ist.

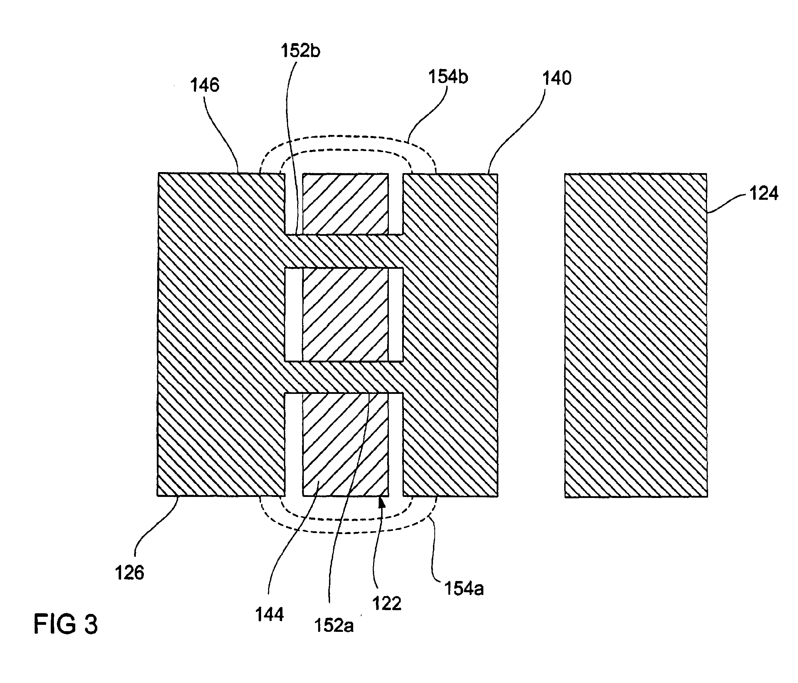

In Fig. 3 wird ein Ausführungsbeispiel des erfindungsgemäßen Transistorbauelements gezeigt, welches basierend auf Fig. 2 eine Verbindung zwischen dem Abschirmelement 140 und dem weiteren Abschirmelement 146 zeigt. Um die elektrische Anbindung zwischen dem Abschirmelement 140 und dem weiteren Abschirmelement 146 zu verbessern, sind zwei elektrisch leitfähige Stege 152a und 152b vorgesehen, welche die zwei Abschirmelemente 140, 146 derart verbinden, dass sich die Stege 152a und 152b über das Gate 122 erstrecken. Der Einfluss der Stege 152a und 152b auf das Gesamtverhalten ist vernachlässigbar. Alternativ können in einem nicht beanspruchten Beispiel die Stege 152a und 152b auch so geführt werden, dass diese das Feld 122 nicht überdecken, wie es in Fig. 3 durch die gestrichelten Linien 154a, 154b andeutet ist. Wie auch bei dem in Fig. 2 beschriebenenBeispiel können bei dem in Fig. 3 gezeigten Ausführungsbeispiel das Abschirmelement 140 und/oder das weitere Abschirmelement 146 mit einem Bezugspotential verbunden sein, wobei vorzugsweise eine Anbindung an das Bezugspotential über den Rückseitenkontakt des Substrats und den Sourcekontakt 126 erfolgt, mit dem das weitere Abschirmelement 146 vorzugsweise verbunden ist. Über die leitfähigen Stege erfolgt dann eine entsprechende Anbindung des Abschirmelements 140 an Masse.

Obwohl oben bevorzugte Ausführungsbeispiele der vorliegenden Erfindung beschrieben wurden, bei denen das Bezugspotential Masse ist, können auch andere, geeignete Potentiale als Bezugspotentiale herangezogen werden.

Ferner wurde die obige Beschreibung anhand eines n-Kanal LDMOS-Transistors durchgeführt, jedoch ist die vorliegende Erfindung nicht hierauf beschränkt, und kann gleichermaßen in einen p-Kanal LDMOS-Transistor eingesetzt werden.

Hinsichtlich der Materialien für das Abschirmelement wird es bevorzugt, Aluminium zu verwenden. Die Abmessungen des Abschirmelements liegen vorzugsweise im Bereich von 1µm.

### Bezugszeichenliste

- 100: Substrat
- 102: untere Oberfläche des Substrats
- 104: obere Oberfläche des Substrats
- 106: Epitaxieschicht
- 108: obere Oberfläche der Epitaxieschicht
- 110: Drainbereich
- 112: erster Drainabschnitt
- 114: zweiter Drainabschnitt
- 116: Sourcebereich
- 118: Kanalbereich
- 120: Gateoxid
- 122: Gate
- 124: Drain
- 126: Source
- 128: Ohmscher p⁺-Kontakt
- 130: p-Bereich
- 132: isolierende Schicht
- 134: obere Oberfläche der isolierenden Schicht
- 136: bekanntes Abschirmelement
- 138: Verbindungselement
- 140: Abschirmelement
- 142: untere Oberfläche des Abschirmelements
- 144: obere Oberfläche des Gates
- 146: weiteres Abschirmelement
- 148: untere Oberfläche des weiteren Abschirmelements
- 150: Verbindungselement
- 152a, 152b: Verbindungssteg
- 154a,154b: Verbindungssteg

## Patentansprüche

1. Transistorbauelement, mit
einem Substrat (100, 106),
einem Sourcebereich (116), der in dem Substrat (100, 106) gebildet ist und mit einem auf einer Substratoberfläche (108) angeordneten Sourcekontakt (126) elektrisch verbunden ist;
einem Drainbereich (110), der in dem Substrat (100, 106) gebildet ist, wobei der Drainbereich (110) einen ersten Drainabschnitt (112) mit einer ersten Dotierungskonzentration und einen zweiten Drainabschnitt (114) mit einer zweiten Dotierungskonzentration aufweist, die niedriger ist als die erste Dotierungskonzentration; und
einer Drainmetallisierung (124), die oberhalb des Drainbereichs (110) angeordnet und elektrisch mit dem ersten Drainabschnitt (112) verbunden ist;
einem Kanalbereich (118) zwischen dem Sourcebereich (116) und dem zweiten Drainabschnitt (114);
einem Gateoxid (120) oberhalb des Kanalbereichs (118);
einem Gate (122) oberhalb des Gateoxids (120) und des Kanalbereichs (118);
einer isolierenden Schicht (132), die derart auf dem Substrat (100, 106) angeordnet ist, dass das Gate (122) durch die isolierende Schicht (132) bedeckt ist;
einem Abschirmelement (140), das innerhalb der isolierenden Schicht (132) oberhalb des Drainbereichs (110) zwischen dem Gate (122) und der Drainmetallisierung (124) angeordnet ist und bezüglich einer Substratoberfläche (108) weiter von derselben beabstandet ist als das Gate (122); und
einem weiteren Abschirmelement (146), das innerhalb der isolierenden Schicht (132) oberhalb des Sourcebereichs (116) und zwischen dem Sourcekontakt (126) und dem Gate (122) angeordnet ist und bezüglich der Substratoberfläche (108) weiter von derselben beabstandet ist als das Gate (122),
**dadurch gekennzeichnet, dass**
das Abschirmelement (140) und das weitere Abschirmelement (146) das Gate (122) nicht überlappen, und
das Abschirmelement (140) und das weitere Abschirmelement (146) über leitfähige Stege (152a, 152b) in der isolierenden Schicht (132) miteinander verbunden sind,
wobei sich die leitfähigen Stege (152a, 152b) zwischen dem Abschirmelement (140) und dem weiteren Abschirmelement (146) über Abschnitte des Gates (122) erstrecken.

2. Transistorbauelement nach Anspruch 1, bei dem die Drainmetallisierung (124) aus zwei übereinander angeordneten Metallisierungsebenen besteht, die elektrisch miteinander verbunden sind, wobei sich die Metallisierungsebenen teilweise oder vollständig überdecken.

3. Transistorbauelement nach Anspruch 1 oder 2, bei dem das Abschirmelement (140) aus zwei übereinander angeordneten Metallisierungsebenen besteht, die elektrisch miteinander verbunden sind, wobei sich die Metallisierungsebenen teilweise oder vollständig überdecken.

4. Transistorbauelement nach Anspruch 2 oder 3, bei dem die zwei übereinander angeordneten Metallisierungsebenen über mit Wolfram gefüllte Verbindungslöcher miteinander verbunden sind.

5. Transistorbauelement nach einem der Ansprüche 1 bis 4, bei dem das Abschirmelement (140) und das weitere Abschirmelement (146) mit einem Bezugspotential verbunden sind.

6. Transistorbauelement nach einem der Ansprüche 1 bis 5, bei dem das weitere Abschirmelement (146) mit dem Sourcekontakt (126) verbunden ist.

7. Transistorelement nach Anspruch 5, bei dem das Bezugspotential Masse ist.

8. Transistorbauelement nach einem der Ansprüche 1 bis 7, bei dem die isolierende Schicht (132) eine Oxidschicht ist.

9. Transistorbauelement nach Anspruch 8, bei dem die isolierende Schicht (132) eine SiO₂-Schicht ist.

10. Transistorbauelement nach einem der Ansprüche 1 bis 9, bei dem das Substrat einen Substratträger (100) und eine darauf gebildete Schicht (106) umfasst, wobei in der Schicht (106) die aktiven Bereiche (110, 112, 114, 116, 118) des Transistorbauelements gebildet sind.

## Claims

1. Transistor device, comprising:
a substrate (100, 106),
a source region (116) formed in the substrate (100, 106) and electrically connected to a source contact (126) arranged on the substrate surface (108);
a drain region (110) formed in the substrate (100, 106), the drain region (110) having a first drain portion (112) with a first doping concentration and a second drain portion (114) with a second doping concentration that is lower than the first doping concentration; and
a drain metallization (124) arranged above the drain region (110) and electrically connected to the first drain portion (112);
a channel region (118) between the source region (116) and the second drain portion (114);
a gate oxide (120) above the channel region (118);
a gate (122) above the gate oxide (120) and the channel region (118);
an insulating layer (132) arranged on the substrate (100, 106) such that the gate (122) is covered by the insulating layer (132);
a shielding element (140) arranged within the insulating layer (132) above the drain region (110) between the gate (122) and the drain metallization (124) and, with respect to a substrate surface (108), being spaced further apart than the gate (122); and
a further shielding element (146) arranged within the insulating layer (132) above the source region (116) and between the source contact (126) and the gate (122), and, with respect to the substrate surface (108), being spaced further apart than the gate (122),
**characterized in that** the shielding element (140) and the further shielding element (146) do not overlap the gate (122), and
the shielding element (140) and the further shielding element (146) are connected to each other via conductive ridges (152a, 152b) in the insulating layer (132),
wherein the conductive ridges (152a, 152b) extend between the shielding element (140) and the further shielding element (146) across portions of the gate (122).

2. Transistor device according to claim 1, wherein the drain metallization (124) consists of two metallization levels arranged above one another that are electrically connected to one another, wherein the metallization levels partly or fully overlap.

3. Transistor device according to claim 1 or 2, wherein the shielding element (140) consists of two metallization levels arranged above one another that are electrically connected to one another, wherein the metallization levels partly or fully overlap.

4. Transistor device according to claims 2 or 3, wherein two metallization levels arranged above one another are connected to one another via tungsten-filled connecting holes.

5. Transistor device according to one of claims 1 to 4, wherein the shielding element (140) and the further shielding element (146) are connected to a reference potential.

6. Transistor device according to one of claims 1 to 5, wherein the further shielding element (146) is connected to the source contact (126).

7. Transistor device according to claim 5, wherein the reference potential is ground.

8. Transistor device according to one of claims 1 to 7, wherein the insulating layer (132) is an oxide layer.

9. Transistor device according to claim 8, wherein the insulating layer (132) is a SiO₂ layer.

10. Transistor device according to one of claims 1 to 9, wherein the substrate comprises a substrate carrier (100) and a layer (106) formed thereon, wherein the active regions (110, 112, 114, 116, 118) of the transistor device are formed in the layer (106).

## Revendications

1. Dispositif transistor, avec
un substrat (100, 106),
une zone de source (116) qui est formée dans le substrat (100, 106) et qui est reliée électriquement à un contact de source (126) disposé sur une surface de substrat (108);
une zone de drain (110) qui est formée dans le substrat (100, 106), la zone de drain (110) présentant un premier segment de drain (112) avec une première concentration de dopage et un deuxième segment de drain (114) avec une deuxième concentration de dopage qui est inférieure à la première concentration de dopage; et
une métallisation de drain (124) disposée au-dessus de la zone de drain (110) et reliée électriquement au premier segment de drain (112);
une zone de canal (118) entre la zone de source (116) et le deuxième segment de drain (114);
un oxyde de porte (120) au-dessus de la zone de canal (118);
une porte (122) au-dessus de l'oxyde de porte (120) et de la zone de canal (118);
une couche isolante (132) qui est disposée sur le substrat (100, 106) de sorte que la porte (122) soit recouverte par la couche isolante (132);
un élément de protection (140) qui est disposé dans la couche isolante (132) au-dessus de la zone de drain (110), entre la porte (122) et la métallisation de drain (124) et qui, par rapport à une surface de substrat (108), est plus éloigné de cette dernière que la porte (122); et un autre élément de protection (146) qui est disposé dans la couche isolante (132) au-dessus de la zone de source (116) et entre le contact de source (126) et la porte (122) et qui, par rapport à une surface de substrat (108), est plus éloigné de cette dernière que la porte (122),
**caractérisé par le fait que**
l'élément de protection (140) et l'autre élément de protection (146) ne viennent pas en recouvrement avec la porte (122), et
l'élément de protection (140) et l'autre élément de protection (146) sont reliés l'un à l'autre par des bretelles conductrices (152a, 152b) dans la couche isolante (132),
les bretelles conductrices (152a, 152b) s'étendant entre l'élément de protection (140) et l'autre élément de protection (146) sur des segments de la porte (122).

2. Dispositif transistor selon la revendication 1, dans lequel la métallisation de drain (124) se compose de deux niveaux de métallisation disposés l'un au-dessus de l'autre et reliés électriquement l'un à l'autre, les niveaux de métallisation se recouvrant partiellement ou totalement.

3. Dispositif transistor selon la revendication 1 ou 2, dans lequel l'élément de protection (140) se compose de deux niveaux de métallisation disposés l'un au-dessus de l'autre et qui sont reliés électriquement l'un à l'autre, les niveaux de métallisation se recouvrant partiellement ou totalement.

4. Dispositif transistor selon la revendication 2 ou 3, dans lequel les deux niveaux de métallisation superposés l'un sur l'autre sont reliés l'un à l'autre par l'intermédiaire de trous de connexion remplis de tungstène.

5. Elément de transistor selon l'une des revendications de 1 à 4, dans lequel l'élément de protection (140) et l'autre élément de protection (146) sont reliés à un potentiel de référence.

6. Dispositif transistor selon l'une des revendications de 1 à 5, dans lequel l'autre élément de protection (146) est relié au contact de source (126).

7. Dispositif transistor selon la revendication 5, dans lequel le potentiel de référence est la masse.

8. Dispositif transistor selon l'une des revendications de 1 à 7, dans lequel la couche isolante (132) est une couche d'oxyde.

9. Dispositif transistor selon la revendication 8, dans lequel la couche isolante (132) est une couche de SiO₂.

10. Dispositif transistor selon l'une des revendications de 1 à 9, dans lequel le substrat comporte un porte-substrat (100) et une couche (106) formée sur ce dernier, dans la couche (106) étant formées les zones actives (110, 112, 114, 116, 118) du dispositif transistor.
